# EUROPEAN PATENT SPECIFICATION

(11) **EP 0 297 932 B1**
(45) Date of publication and mention of the grant of the patent: **12.01.1994**
(21) Application number: 88400859.0
(22) Date of filing: 08.04.1988
(51) Int. Cl.: H03K 19/094, H03K 19/003

(54) **Bus transmitter having controlled trapezoidal slew rate**
Bussender mit gesteuerter, trapezförmiger Ausgangsspannung
Transmetteur de bus ayant une tension de sortie trapézoidale commandée

(30) Priority: 29.06.1987 US 67945
(43) Date of publication of application: 04.01.1989
(73) Proprietor: DIGITAL EQUIPMENT CORPORATION, Maynard, MA 01754 (US)
(72) Inventor: Grondalski, David S., Cambridge Massachusetts 02138 (US)
(74) Representative: Mongrédien, André

(56) References cited:
- EP-A- 0 143 699
- EP-A- 0 164 615
- US-A- 4 504 779
- US-A- 4 593 206
- PATENT ABSTRACTS OF JAPAN, vol. 9. no. 69 (E-305) (1972), 29 March 1985
- PATENT ABSTRACTS OF JAPAN, vol 11, no. 83 (E-489) (2530), 13 March 1987
- E. Hoelzer ,H. Holzwarth " Pulstechnik-Band II Anwendungen und Systeme", pages 152-155
- Siemens AG, "Digitale Schaltungen,MOS-Datenbuch 1974/75 Band 1", pages 372-375,378-380,394,395,396

## Description

### BACKGROUND OF THE INVENTION

### 1. Field of the Invention

The invention relates generally to the field of electronic circuits, and more specifically to circuits for transmitting signals over buses in digital data processing systems.

### 2. Description of the Prior Art

A digital data processing system includes a number of functional units, including one or more processors, memories, and input/output devices such as mass storage devices, video display terminals, printers and telecommunications devices, all interconnected by one or more buses. The buses carry signals representing information among the various units comprising the system, as well as control signals which, inter alia, control the transfer of the information signals.

Generally, a bus is a set of wires to which several functional units may connect in parallel. When a unit transmits a signal over a wire in a bus, the signal may be reflected when it reaches an end of the bus. Reflected signals may interfere with signals that are later transmitted over the bus wire, which may cause signaling errors over the bus. A major problem with signal reflections is that they can corrupt later transmitted signals. Accordingly, a system designer may have to provide a sufficient delay time following a transmission before another transmission can take place to minimize likely interference from signal reflections.

Alternatively, the system designer may be able to configure the bus or the signals transmitted thereover to minimize reflections. For example, the wires of some include resistor networks at each end which assist in reducing reflections. Power for the bus can also be provided through these bus terminator networks.

In addition, the shape of the signal waveform may be adjusted so as to minimize reflections and crosstalk between signals on different bus lines. In particular, a signal's waveform may be relatively square, in which the voltage level of the bus wire changes relatively abruptly between a high and a low voltage level. Such a signal waveform permits fast signaling, but it also is most likely to cause signal reflections and crosstalk.

On the other hand, if the signals are "trapezoidal" in which voltage levels of the signals change between the high and low levels at a less abrupt, but still rapid, rate, the likelihood of reflections can be minimized. The transmitters which produce such signals must be able to control the rate of change of the voltage on the wires, that is, the "slew rate", within selected limits. This problem is compounded since, in most systems, the buses must be able to handle widely varying numbers of units connected thereto, which, in turn, results in widely varying capacitive load conditions which can vary the slew rate of the signals transmitted over the bus wires.

Currently, transmitters capable of producing trapezoidal signal waveforms are implemented using bipolar transistor devices in combination with discrete resistors and other components whose electrical values can be controlled to a high level of accuracy. Most of the circuits comprising the functional units of digital data processing systems are implemented using MOSFET (metal-oxide-semiconductor field effect transistor) devices, and the bipolar transmitter circuits ore implemented separate and apart from the other components comprising the units, which take up a considerable amount of space on the printed circuit boards on which the circuit elements comprising the units are mounted. In addition, the bipolar transmitters, because they are discrete, bipolar and separate from the other devices, require large amounts of electrical power and provide extra delay in the transmitted signal.

US-A-4 504 779 describes a circuit for varying the power supplied from a D.C. power supply to a moderate to high powered load such as a motor. Trapezoidal voltage and current wave forms are used approaching the maximum load power delivery available from sine wave drives and the minimum dissipation in the driver circuitry available with square wave drives, while at the same time minimizing the generation of undesirable electromagnetic interference. This patent shows the use of gate to drain capacitor in tandem with gate to source capacitor to control the gate voltage of power MOSFET transistor.

EP-A-0 164 615 describes an off-chip driver circuit including a first output device and a second ouput device having a common out put connection wherein a rising or falling signal is applied through an input circuit to the output devices. The output signal which appears at the common output connect ion will exhibit a rise time and a fall time corresponding to the rise and fall of the input signal. A first monitoring device is connected to the output signal to monitor the rise time of the output signal and a second monitoring device is connected to the output signal to monitor the fall time of the output signal. A ramp generator is provided which generates a reference signal which also includes a rise time and a fall time. The two monitor circuits compare the rise an fall times of the output signal with the reference rise time and reference fall time to produce a feedback signal to control the rise and fall times of the output signal in accordance with the reference signal.

### SUMMARY OF THE INVENTION

The invention provides a new and improved transmitter circuit implemented using MOSFET devices for producing signals with trapezoidal waveforms for transmission over a bus.

In brief summary, the new bus transmitter circuit includes a MOSFET bus driver transistor driven by a buffer circuit having pull-up and pull-down transistors current through which is controlled by constant current sources. The gate to drain capacitance C_{GD} of the driver transistor is substantially higher than other capacitances at the gate terminal. The gate terminal of the driver transistor is connected to, and controlled by, the node between the pull-up and pull-down transistors. The drain terminal of the driver transistor is connected to, and controls, a bus line. To assert a signal on the bus line, the pull-up transistor is turned on to drive current into the node at a rate governed by the current source, which increases the voltage level of the node. When the voltage level of the node reaches the driver transistor's threshold level, the driver transistor begins to turn on, allowing the voltage level of the bus line to drop. Contemporaneously, current begins to flow into the node from the bus line through the driver transistor's gate to drain capacitance, thereby limiting the voltage level of the node, and thus the current flow through the driver transistor. Thus, current flows through the driver transistor from the bus line in a manner controlled, in part, by the rate of change of the voltage level on the bus line, thereby accomplishing the trapezoidal slew in the signal on the bus line. In negating a signal on the bus line, the operations are similar, with current flowing out of the node through the pull-down transistor and the driver transistor's gate to drain capacitance.

The invention is directed to a A bus transmitter circuit comprising :
A. a driver including a MOSFET driver transistor having a drain terminal for connection to a bus line a gate terminal connected to a control node and a source terminal for connection to a source power supply,
B. a control buffer including a switched pull-up comprising a pull-up transistor and a pull-up current source, and a switched pull-down, comprising a pull-down transistor and a pull-down current source, said pull-up transistor and said pull-down transistor being connected to said control node, said switched pull-up transistor and said switched pull-down transistor being further connected to receive a data input signal to control the control node of said driver in response to the condition of said data input signal, current through said pull-up transistor and said pull-down transistor to said control node being controlled by the respective current source to turn said driver on and off in a controlled manner,
characterized in that said pull up and pull down transistors are MOSFET transistors,
said pull-up transistor having a selected conductivity type end includes a source terminal connected to said pull-up current source, a drain terminal connected to said control node, and a gate terminal; and
said pull-down transistor having a different conductivity type than said pull-up transistor, said pull-down transistor having a source terminal connected to said pull-down current source, a drain terminal connected to said control node, and a gate terminal;
the gate terminals of both said pull-up transistor and said pull-down transistor being connected to receive said data input signal.
and that said MOSFET driver transistor has a relatively high inherent capacitance between its drain terminal and its gate terminal which substantially dominates other capacitances at said gate terminal to thereby provide an internal feedback path between said drain terminal and
said internal feedback path providing a bidirectional path through said inherent capacitance for current flow between said control node and said bus to selectively control the voltage level of a signal at said control node and thereby control the rate at which said driver turns on and off in response to said data input signal.

This invention is pointed out with particularity in the appended claims. The above and further advantages of this invention may be better understood by referring to the following description taken in conjunction with the accompanying drawings, in which:
Fig. 1 is a schematic circuit diagram of a digital data bus transmitter constructed in accordance with the invention;
Fig. 2 is a diagram depicting signal waveforms at two points of the circuit depicted in Fig. 1, which is useful in understanding the transmitter depicted in Fig. 1.

### DETAILED DESCRIPTION OF AN ILLUSTRATIVE EMBODIMENT

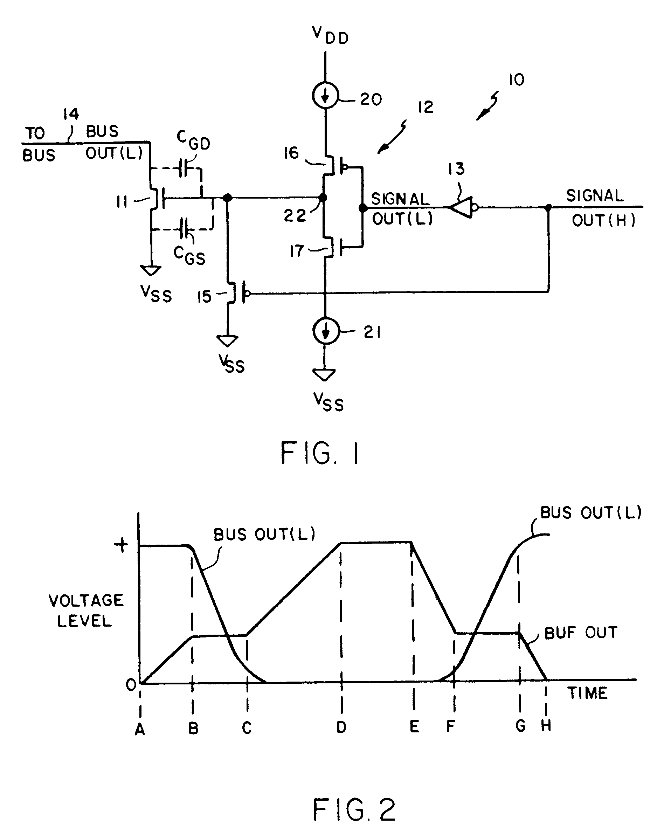

With reference to Fig. 1, a transmitter 10 constructed in accordance with the invention includes a bus driver transistor 11 whose gate terminal receives an BUF OUT buffer out digital data signal from a buffer circuit 12 in the form of an inverter. In response to an asserted (that is, high) BUF OUT buffer out signal from buffer circuit 12, the bus driver transistor turns on to transmit a BUS OUT (L) bus out (asserted low) digital data signal over a bus line 14. The bus driver transistor 11 has a drain terminal which is connected directly to the bus line 14, and a source terminal which is connected to a V_{SS} power supply, which is effectively at the ground voltage level. The bus driver transistor 11 is an n-type metal-oxide-semiconductor field effect transistor (MOSFET).

The buffer circuit 12, in turn, includes a p-type pull-up transistor 16 and an n-type pull-down transistor 17 connected between two constant current sources 20 and 21. Current source 20 is connected to a V_{DD} power supply and controls the current which is coupled to the drain terminal of pull-up transistor 16. The source terminal of pull-up transistor 16, in turn, is connected to a node 22, to which the drain terminal of pull-down transistor 17 is also connected. The source terminal of the pull down transistor 17, in turn, is connected to a current source 21, which controls the current which flows therethrough from the node 22 to the V_{SS} power supply. The BUF OUT inverter output signal, which is coupled to the gate terminal of bus driver transistor 11, is provided at the node 22 between the source terminal of the pull-up transistor 16 and the drain terminal of the pull-down transistor 17. Returning to transistor 11, that transistor has a high capacitance between its gate and drain terminals (shown as C_{GD} in Fig. 1) in comparison to other capacitances at node 22, so that the gate to drain capacitance C_{GD} substantially dominates other sources of capacitance on node 22.

The gate terminals of the pull-up transistor 16 and the pull-down transistor 17 are controlled in tandem by a SIG OUT (H) signal output (asserted high) signal from an inverter 13 which, in turn, inverts a SIG OUT (L) signal output (asserted low) signal from other circuitry (not shown). The SIG OUT (L) signal output (asserted low) signal also controls a p-type transistor 15 whose drain terminal is connected to the node 22 and whose source terminal is connected to the V_{SS} power supply.

Initially, the SIG OUT (H) signal output (asserted high) signal is in a low voltage (negated) condition. As a result, transistor 15 is on. Inverter 13 complements the SIG OUT (H) signal output (asserted high) signal to provide a high voltage level (negated) SIG OUT (L) signal output (asserted low) signal, which, in turn, maintains transistor 17 in an on condition and transistor 16 in an off condition. At this point, charge from node 22 has been transferred through current source 21 to the V_{SS} source voltage level (that is, ground), and so the BUF OUT buffer output signal is at a low voltage level. In addition, since driver transistor 11 is off, the BUS OUT (L) bus out (asserted low) signal is at a high voltage level (thereby providing a signal having a negated logic level), as shown at time A (Fig. 2).

When the SIG OUT (H) signal output (asserted high) signal shifts from the negated (low voltage) condition to the asserted (high voltage) condition, the transistor 15 turns off. In addition, the inverter 13 complements the SIG OUT (H) signal output (asserted high) signal to form a SIG OUT (L) signal output (asserted low) signal in a low voltage (asserted) condition. As a result, the transistor 17 turns off blocking the current path from node 22 through the current source 21 to the V_{SS} power supply. In addition, the SIG OUT (L) signal output (asserted low) signal turns transistor 16 on, thereby creating a path to node 22 from the V_{DD} supply through current source 20.

Since transistor 16 is on, the voltage level of the BUF OUT buffer output signal begins to rise, as shown from time A to time B in Fig. 2. At time B (Fig. 2) the voltage level of the BUF OUT buffer output signal has risen to the threshold voltage level, and so the bus driver transistor 11 begins to turn on. This, in turn, enables current from bus line 14 to flow through the bus driver transistor 11, causing the voltage level of the BUS OUT (L) bus out (asserted low) signal to drop, as shown immediately after time B (Fig. 2). However, since the C_{GD} gate to drain capacitance of the bus driver transistor 11 is a relatively large proportion of the total capacitance on node 22, current also is injected into node 22 from bus line 14 through the C_{GD} gate to drain capacitance. Thus, the C_{GD} gate to drain capacitance provides a feedback path so that the BUS OUT (L) bus output (asserted low) signal effects the voltage level of node 22.

Since at this point two sources, namely current source 20 (through pull-up transistor 16) and bus line 14 (through the C_{GD} gate to drain capacitance of bus driver transistor 11), are forcing current into node 22 from opposite directions, the voltage level of node 22 with respect to ground (that is, the voltage level of the V_{SS} source power supply), the voltage level of the node 22 does not change, as shown between times B and C in Fig. 2. Accordingly, the voltage level on the gate terminal of the bus driver transistor 11 is maintained at about the threshold level, so that the transistor 11 is maintained on, but at a level at which the voltage level of the bus line 14 falls at a controlled rate. That is, the voltage of the BUS OUT (L) bus out (asserted low) signal changes from a high level to a low level over a time period that is related to the C_{GD} gate to drain capacitance of the bus driver transistor 11 and the current flow provided by current source 20.

As the voltage level of the BUS OUT (L) bus out (asserted low) signal on bus line 14 completes its downward transition, the rate at which current is injected into the node 22 through the C_{GD} gate to drain capacitance from the bus line 14 also drops. As a result, the current injected into node 22 from current source 20 through pull-up transistor 16 dominates node 22, and the voltage level of node 22 again begins increasing, as shown between times C and D (Fig. 2). The rate of increase depends on the capacitance of the node 22, including the C_{GD} gate to drain capacitance, and the current supplied by current source 20. At time D (Fig. 2) the node 22 is charged to the maximum voltage level. At this point, the bus driver transistor 11 is fully on, and node 22 is fully charged, as shown by the high BUF OUT buffer output signal at time D, Fig. 2. Furthermore, by time D, the BUS OUT (L) bus out (asserted low) signal is fully asserted, that is, it is at the low voltage level.

The BUF OUT buffer output signal remains at a high voltage level, and the BUS OUT (L) bus out (asserted low) signal remains at a low voltage level, until time E. At time E, the SIG OUT (H) signal output (asserted high) signal is negated, that is, it is driven to a low voltage level. As a result, the inverter 13 complements the low SIG OUT (H) signal output (asserted high) signal to provide a high SIG OUT (L) signal output (asserted low) signal. The high SIG OUT (L) signal output (asserted low) signal, in turn, turns off pull-up transistor 16, thereby turning off the current path from current source 20 to node 22, and turns on pull-down transistor 17, thereby providing a current path from node 22 to current source 21.

In addition, the high SIG OUT (H) signal output (asserted high) signal turns on transistor 15, which provides a current path directly between node 22 and the ground voltage level provided by the V_{SS} source power supply. The current path through transistor 15 permits the node 22 to be quickly discharged to the threshold voltage level of the transistor 15, between times E and F (Fig. 2). In one specific embodiment, in which the transistor 15 is a p-type transistor, transistor 15 allows the voltage level of the node 22 to drop to about two and a half volts from a five volt fully charged condition. Some current also flows out of node 22 through pull-down transistor 17 and current source 21 during this time, but the primary current path is through transistor 15. After sufficient current has flowed out of node 22 to bring the voltage level of the node 22 to the threshold level of bus driver transistor 11, the bus driver transistor 11 begins to turn off, allowing the voltage level of the BUS OUT (L) bus out (asserted low) signal to rise, to thereby negate the BUS OUT (L) bus out (asserted low) signal.

Around time F, when the voltage difference between the drain terminal of transistor 15 with respect to its gate terminal has fallen to the transistor's threshold level, the transistor 15 essentially turns off. However, current attempts to continue to flow out of node 22 through pull-down transistor 17 and current source 21. Contemporaneously, current continues to flow out of node 22 in the opposite direction, that is, through the gate to drain capacitance C_{GD} of bus driver transistor 11. Since current is drawn from node 22 in opposite directions, the voltage level of the node 22, which provides the BUF OUT buffer output signal, is constant, as shown at times F-G, Fig. 2, at a level sufficient to maintain transistor 11 on at a controlled level. This allows the voltage level of the BUS OUT (L) bus output (asserted low) signal to increase at a steady controlled rate during that time period, as shown in Fig. 2.

At time G, the gate to drain capacitance C_{GD} stops drawing charge from node 22, and so charge leaves node 22 only through transistor 17, which is still on, at a rate controlled by the current source 21. Accordingly, the voltage level of node 21 falls to the V_{SS} source power supply level, which is the ground level for the transmitter circuit 10. Accordingly, the BUF OUT (L) buffer output (asserted low) signal drops at a controlled rate between times G-H (Fig. 2) as shown in Fig. 2.

It will be appreciated that the transistor 15 is provided to reduce the time E-F required to pull the voltage level of node 22 to the point at which bus driver transistor 11 begins to turn off. In the absence of transistor 15, the current instead flow through pull-down transistor 17 and current source 21, but since the current source 21 limits the flow of current, a longer time is required to bring the voltage of node 22 to the point at which the driver transistor 11 starts to turn off.

It addition, it will be recognized that the large gate to drain capacitance C_{GD} essentially provides a feedback path allowing the BUS OUT (L) bus output (asserted low) signal to, in part, control the voltage level on node 22, which, in turn, controls the rise and fall of the signal. This results in a BUS OUT (L) bus output (asserted low) signal having a leading edge (between times B-C, Fig. 2) and a trailing edge (between times F-G, Fig. 2) having suitable rise and fall times, to thereby provide a "trapezoidal" signal. This signal shape reduces the ringing and other noise inherent in signals having very short (that is, rectangular) rise and fall times. This signal shape is accomplished by having a large gate to drain capacitance C_{GD} which substantially dominates the total capacitance at the gate terminal of the driver transistor to facilitate current flow through the gate to drain capacitance C_{GD} during signal transitions of the BUS OUT (L) bus output (asserted low) signal, as described above.

## Claims

1. A bus transmitter circuit comprising :
A. a driver including a MOSFET driver transistor (11) having a drain terminal for connection to a bus line (14), a gate terminal connected to a control node (22) and a source terminal for connection to a source power supply (V_{SS}).
B. a control buffer (12) including a switched pull-up comprising a pull-up transistor (16) and a pull-up current source (20), and a switched pull-down, comprising a pull-down transistor (17) and a pull-down current source (21), said pull-up transistor and said pull-down transistor being connected to said control node, said switched pull-up transistor and said switched pull-down transistor being further connected to receive a data input signal to control the control node of said driver in response to the condition of said data input signal, current through said pull-up transistor and said pull-down transistor to said control node being controlled by the respective current source to turn said driver on and off in a controlled manner,
characterized in that said pull-up and pull-down transistors are MOSFET transistors,
said pull-up transistor having a selected conductivity type and including a source terminal connected to said pull-up current source, a drain terminal connected to said control node, and a gate terminal, and
said pull-down transistor having a different conductivity type than said pull-up translator, said pull-down transistor having a source terminal connected to said pull-down current source, a drain terminal connected to said control node, and a gate terminal;
the gate terminals of both said pull-up transistor and said pull-down transistor being connected to receive said data input signal.
and that said MOSFET driver transistor has a relatively high inherent capacitance (C_{GD}) between its drain terminal and its gate terminal which substantially dominates other capacitances at said gate terminal to thereby provide an internal feedback path between said drain terminal and
said internal feedback path providing a bidirectional path through said inherent capacitance for current flow between said control node and said bus to selectively control the voltage level of a signal at said control node and thereby control the rate at which said driver turns on and off in response to said data input signal.

2. A bus transmitter circuit as defined in claim 1 further comprising a driver pull-down transistor (15) connected to the control node (22) and controlled by a pull-down control signal complementary to the data input signal to condition the control node to a selected level when the data input signal shifts levels to thereby facilitate a rapid turn-off of the driver transistor.

3. A bus transmitter circuit as defined in claim 1 further comprising an inverter for receiving said pull-down control signal and producing said data input signal as the complement of said pull-down control signal.

4. A bus transmitter circuit as defined in claim 2 further comprising an inverter for receiving said pull-down control signal and producing said data input signal as the complement of said pull-down control signal.

## Patentansprüche

1. Bus-Übertragerschaltkreis, der folgendes aufweist:
A. einen Treiber mit einem MOSFET-Treibertransistor (11), der einen Drain-Anschluß zum Anschluß an eine Busleitung (14), einen Gate-Anschluß, der an einem Steuerknoten (22) angeschlossen ist, und einen Source-Anschluß zum Anschluß an eine Source-Stromversorgung (V_{SS}) aufweist,
B. einen Steuerpuffer (12) mit einem geschalteten Pull-up, der einen Pull-up-Transistor (16) und eine Pull-up-Stromquelle (20) aufweist, und mit einem geschalteten Pull-down, der einem Pull-down-Transistor (17) und eine Pull-down-Stromquelle (21) aufweist, wobei der Pull-up- und der Pull-down-Transistor an dem Steuerknoten angeschlossen sind, wobei der geschaltete Pull-up-Transistor und der geschaltete Pull-down-Transistor weiterhin derart angeschlossen sind, daß sie ein Dateneingangssignal zum Steuern des Steuerknotens des Treibers in Antwort auf den Zustand des Dateneingangssignals empfangen, wobei Strom durch den Pull-up-Transistor und den Pull-down-Transistor zu dem Steuerknoten durch die jeweilige Stromquelle zum Ein- und Ausschalten des Treibers auf kontrollierte Weise gesteuert wird,
dadurch gekennzeichnet, daß
der Pull-up- und der Pull-down-Transistor MOSFET-Transistoren sind,
wobei der Pull-up-Transistor vom Typ einer ausgewählten Leitfähigkeit ist und einen Source-Anschluß, der an die Pull-up-Stromquelle angeschlossen ist, einen Drain-Anschluß, der an den Steuerknoten angeschlossen ist, und einen Gate-Anschluß aufweist, und
wobei der Pull-down-Transistor vom Typ einer Leitfähigkeit ist, die unterschiedlich zu der des Pull-up-Transistors ist, wobei der Pull-down-Transistor einen Source-Anschluß, der an die Pull-down-Stromquelle angeschlossen ist, einen Drain-Anschluß, der an dem Steuerknoten angeschlossen ist, und einen Gate-Anschluß aufweist,
wobei die Gate-Anschlüsse sowohl des Pull-up-Transistors als auch des Pull-down-Transistors derart geschaltet sind, daß sie die Dateneingangssignale empfangen,
und daß der MOSFET-Treibertransistor eine relativ hohe Eigenkapazität (C_{GD}) zwischen seinem Drain-Anschluß und seinem Gate-Anschluß aufweist, die andere Kapazitäten an dem Gate-Anschluß im wesentlichen dominiert, wodurch ein interner Rückführpfad zwischen dem Gate- und dem Drain-Anschluß bereitgestellt wird, und
wobei der interne Rückführpfad für einen Stromfluß zwischen dem Steuerknoten und dem Bus einen bidirektionalen Pfad durch die Eigenkapazität bereitstellt, um den Spannungspegel eines Signals an dem Steuerknoten selektiv zu steuern und dadurch die Rate zu steuern, mit der der Treiber in Antwort auf das Dateneingangssignal ein- und ausschaltet.

2. Bus-Übertragerschaltkreis nach Anspruch 1, der weiterhin einen Treiber-Pull-down-Transistor (15) aufweist, der an dem Steuerknoten (22) angeschlossen ist und durch ein zu dem Dateneingangssignal komplementäres Pull-down-Steuersignal gesteuert wird, um den Steuerknoten auf einen ausgewählten Pegel einzustellen, wenn das Dateneingangssignal Pegel verschiebt, um dadurch ein schnelles Ausschalten des Treibertransistors zu ermöglichen.

3. Bus-Übertragerschaltkreis nach Anspruch 1, der weiterhin einer Inverter zum Empfangen des Pull-down-Steuersignals und zum Erzeugen des Dateneingangssignals als das Komplement des Pull-down-Steuersignals aufweist.

4. Bus-Übertragerschaltkreis nach Anspruch 2, dar weiterhin einen Inverter zum Empfangen des Pull-down-Steuersignals und zum Erzeugen des Dateneingangssignals als das Komplement des Pull-down-Steuersignals aufweist.

## Revendications

1. Circuit transmetteur de bus comprenant :
A. un circuit de commande incluant un transistor à effet de champ à métal-oxyde-semiconducteur MOSFET de commande (11) ayant une borne de drain pour une connexion à une ligne de bus (14), une borne de grille connectée à un noeud de commande (22) et une borne de source pour une connexion à une source de tension d'alimentation (V_{SS}),
B. un tampon de commande (12) incluant un circuit de charge commuté comprenant un transistor de charge (16) et une source de courant de charge (20), et un circuit de décharge commuté, comprenant un transistor de décharge (17) et une source de courant de décharge (21), ledit transistor de charge et ledit transistor de décharge étant connectés audit noeud de commande, ledit transistor de charge commuté et ledit transistor de décharge commuté étant en outre connectés pour recevoir un signal d'entrée de données pour commander le noeud de commande dudit circuit de commande en réponse à l'état dudit signal d'entrée de données, le courant dans ledit transistor de charge et dans ledit transistor de décharge vers ledit noeud de commande étant contrôlé par la source de courant respective pour rendre conducteur et bloquer ledit circuit de commande d'une manière contrôlée,
caractérisé en ce que lesdits transistors de charge et de décharge sont des transistors MOSFET,
ledit transistor de charge ayant un type de conductivité sélectionné et incluant une borne de source connectée à ladite source de courant de charge, une borne de drain connectée audit noeud de commande, et une borne de grille ; et,
ledit transistor de décharge ayant un type de conductivité différent que ledit transistor de charge, ledit transistor de décharge ayant une borne de source connectée à ladite source de courant de décharge, une borne de drain connectée audit noeud de commande, et une borne de grille ;
les bornes de grille dudit transistor de charge et dudit transistor de décharge étant toutes les deux connectées pour recevoir ledit signal d'entrée de données,
et en ce que ledit transistor MOSFET de commande a une capacité propre relativement élevée C_{GD} entre sa borne de drain et sa borne de grille, qui domine substantiellement les autres capacités à ladite borne de grille pour fournir ainsi une voie de réaction interne entre ladite borne de drain et ladite borne de grille, et
ladite voie de réaction interne fournissant une voie bidirectionnelle par ladite capacité propre pour le passage d'un courant entre ledit noeud de commande et ledit bus afin de contrôler sélectivement le niveau de tension d'un signal audit noeud de commande et de contrôler ainsi la vitesse à laquelle ledit circuit de commande est rendu conducteur et bloqué en réponse audit signal d'entrée de données.

2. Circuit transmetteur de bus selon la revendication 1, comprenant en outre un transistor de décharge de commande (15) connecté au noeud de commande (22) et commandé par un signal de commande de décharge complémentaire du signal d'entrée de données pour conditionner le noeud de commande à un niveau sélectionné quand le signal d'entrée de données change les niveaux afin de faciliter ainsi un blocage rapide du transistor de commande.

3. Circuit transmetteur de bus selon la revendication 1, comprenant en outre un inverseur pour recevoir ledit signal de commande de décharge et produire ledit signal d'entrée de données comme le complément dudit signal de commande de décharge.

4. Circuit transmetteur de bus selon la revendication 2, comprenant en outre un inverseur pour recevoir ledit signal de commande de décharge et produire ledit signal d'entrée de données comme le complément dudit signal de commande de décharge.
